# EUROPEAN PATENT APPLICATION

(11) **EP 4 273 292 A1**
(43) Date of publication of application: **08.11.2023**
(21) Application number: 22171978.4
(22) Date of filing: 06.05.2022
(51) Int. Cl.: C23C 14/04, C23C 14/56, C23C 14/54, H01J 37/32, H01J 37/34

(54) **DEVICE FOR VACUUM DEPOSITION SYSTEM AND SYSTEM FOR VACUUM DEPOSITION**

(71) Applicant: Bühler Alzenau GmbH, 63755 Alzenau (DE)
(72) Inventor: Mücke, Michael, 61206 Wöllstadt (DE)
(74) Representative: Vossius & Partner Patentanwälte Rechtsanwälte mbB

(57) **Abstract**

The present disclosure relates to a device for vacuum deposition systems, comprising: a movable main body, at least one deposition source mounted on the movable main body, at least one coating window associated with the at least one deposition source and mounted on the movable main body, and at least one cooling device connected to the at least one coating window and mounted on the movable main body.

## Description

The present disclosure generally relates to devices for vacuum deposition systems and systems for vacuum deposition.

Systems for coating films onto subtsrates in a vacuum often use Physical Vapor Deposition (PVD) or Chemical Vapor Deposition (CVD) processes. Contrary to printing, the coating sources have a necessary distance to the film. The coating processes can only be aligned with the substrate to a limited extent. As a result, in addition to the substrate, the inside of the vacuum chamber, which encloses the source and the substrate, is also coated. This accepted unproductive coating contaminates the surroundings. Therefore, periodic cleaning is necessary.

To simplify the cleaning, the chambers are usually provided with plates/parts that can be easily changed for cleaning. In particular, coating windows used as masking limits the coating on the substrate. To achieve a high coating homogeneity on the substrate, the edge of the coating window is heavily coated during the deposition process. As a consequence, the coating window becomes hot. In flexible coating systems, the substrate is made of a temperature-sensitive film. The maximum temperature tolerance of the film and the temperature of the coating window limit the maximum coating rate.

In prior art systems, the substrate is cooled by a chill roll during coating. In known processes and equipments, the coating window is suitably connected to the chill roll to ensure a sufficient cooling. This leads to difficult and costly assembly conditions. In particular, the coating window can only be removed from the system with great effort. The chill roll and shield are moved against each other and cooling remains restricted. Since regular cleaning of the coating the coating window is indispensable, this has a negative effect on the productivity of the system.

Prior art the systems comprise a chamber with a cooled coating roller that moves the substrate along in front of the PVD sources. The coating sources are on a trolley to move the sources out of the vacuum chamber (deposition chamber) for maintenance. The coating trolley closes the vacuum chamber. On the trolley are the magnetron cathodes/coating sources with shields for receiving the recoating (backcoating), other components and a cooling system underneath the vacuum chamber. The shields are attached to the cooling system. The coating windows are mounted in the vacuum chamber for better cooling. Installation and removal is time-consuming.

It is an object of the present invention to provide devices for vacuum deposition systems and systems for vacuum deposition that overcome the above mentioned limitations of the prior art. One object of the invention is to provide coating windows that are easy to change and that remain sufficiently cold to achieve high deposition rates. The object is achieved with the features of the independent claims. Dependent claims define preferred embodiments of the invention.

The present disclosure provides a device for vacuum deposition systems, comprising: a movable main body, at least one deposition source mounted on the movable main body, at least one coating window associated with the at least one deposition source and mounted on the movable main body, and at least one cooling device connected to the at least one coating window and mounted on the movable main body.

Various embodiments may preferably implement the following features.

Preferably, the movable main body is movable relative to a vacuum chamber of a vacuum deposition system such that the movable main body can be inserted into and withdrawn from the vacuum chamber.

Preferably, the movable main body closes the vacuum chamber when completely inserted therein.

Preferably, the at least one coating window comprises a housing with an opening.

Preferebaly, the opening is located at a side of the coating window that (in use) faces a substrate to be coated.

Preferably, the housing comprises sidewalls extending substantially in a deposition direction.

Preferably, the hosuing comprises frontwalls extending substantially perpendicular to the deposition direction.

Preferably, the frontwalls comprises the opening therein.

Preferably, the at least one depositon source is configured to deposit material within a deposition space with a main deposition direction aligned towards the opening of the at least one coating window.

Preferably, the housing of the at least one coating window is configured to surround the at least one deposition source within the deposition space such that material that is not deposited through the opening is deposited on an inner side of the housing.

Preferably, each of the at least one coating window is associated with a respective one of the at least one deposition source.

Preferably, the device further comprises at least one shield located between the at least one deposition source and the at least one coating window, wherein the at least one shield and the at least one coating window are connected to the at least one cooling device.

That is, according to a preffered embodiment, a shield is carefull designed to receive most of the unused coating material, i.e. backcoating that is the coating material that is not deposited on the substrate. This reduces the heat of the coating window and helps to overcome limitations in coating speed of the prior art.

Preferably, the at least one shield and the at least one coating window are connected to separate cooling devices or more preferably to one and the same cooling device.

Preferably, the at least one shield is configured to shield a majority of the at least one coating window.

Preferably, the at least one shield comprises a shield housing with a shield opening, wherein the shield opening is aligned with the opening of the at least one coating window.

Preferably, the shield housing is located between the at least one deposition source and the at least one coating window with a predetermined spacing with respect to the coating window.

Preferably, the shield opening is larger by a predetermined amount than the opening of the at least one coating window.

Preferably, the shield has substantially the same shape as the coating window.

Preferably, the at least one cooling device is connected to the at least one shield.

The present disclosure also provides a system for vacuum deposition, comprising: a vacuum chamber, a substrate carrier located within the vacuum chamber and having a vacuum chamber cooling device configured to cool the subtsrate carrier, and a device for vacuum deposition systems as described above.

Various embodiments may preferably implement the following features.

Preferably, the movable main body is movable relative to the vacuum chamber such that the movable main body can be inserted into and withdrawn from the vacuum chamber.

Preferably, the substrate carrier is configured to hold a substrate, and wherein the substrate carrier is aligned with the at least one coating window such that material can be deposited onto the subtsrate through the at least one coating window.

Preferably, the vacuum chamber cooling device and the at least one cooling device are separate devices.

Preferably, in accordance with the above, the shield is mounted on the cathode trolley for ease of maintenance. A connection to the cooling system is preferably ensured. Due to the long distance to the heat sink, the cooling efficiency is limited.

The present disclosure also provides a device for vacuum deposition systems, comprising: at least one deposition source, at least one coating window associated with the at least one deposition source, at least one cooling device connected to the at least one coating window, and at least one shield located between the at least one deposition source and the at least one coating window, wherein the at least one shield and the at least one coating window are connected to the at least one cooling device.

That is, according to a preffered embodiment, a shield is carefull designed to receive most of the unused coating material, i.e. backcoating that is the coating material that is not deposited on the substrate. This reduces the heat of the coating window and helps to overcome limitations in coating speed of the prior art.

As outlined above, shields are preferably formed so that most of the backcoating is received by them instead of the coating windows. Thus, the amount of backcoating on the coating windows is reduced.

The shields are preferably positioned so that thermal deformation does not affect the coating process. Preferably, the shields are configured such that high temperatures of the shields do not lead to heating of the substrate.

Shields and coating windows and their cooling are preferably optimized to minimize substrate heating. Thus, the shields, and not the coating window, may become hot and deform.

The exemplary embodiments disclosed herein are directed to providing features that will become readily apparent by reference to the following description when taken in conjunction with the accompany drawings. In accordance with various embodiments, exemplary systems, methods, devices and computer program products are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present disclosure.

Thus, the present disclosure is not limited to the exemplary embodiments and applications described and illustrated herein. Additionally, the specific order and/or hierarchy of steps in the methods disclosed herein are merely exemplary approaches. Based upon design preferences, the specific order or hierarchy of steps of the disclosed methods or processes can be re-arranged while remaining within the scope of the present disclosure. Thus, those of ordinary skill in the art will understand that the methods and techniques disclosed herein present various steps or acts in a sample order, and the present disclosure is not limited to the specific order or hierarchy presented unless expressly stated otherwise.

The above and other aspects and their implementations are described in greater detail in the drawings, the descriptions, and the claims.
Fig. 1 is a sectional drawing along the coating direction according to an embodiment of the present disclosure.
Fig. 2 is a sectional drawing transverse to the coating direction according to the embodiment of Fig. 1.
Fig. 3 is a sectional drawing along the coating direction according to another embodiment of the present disclosure.
Fig. 4 is sectional drawing transverse to the coating direction according to the embodiment of Fig. 3.

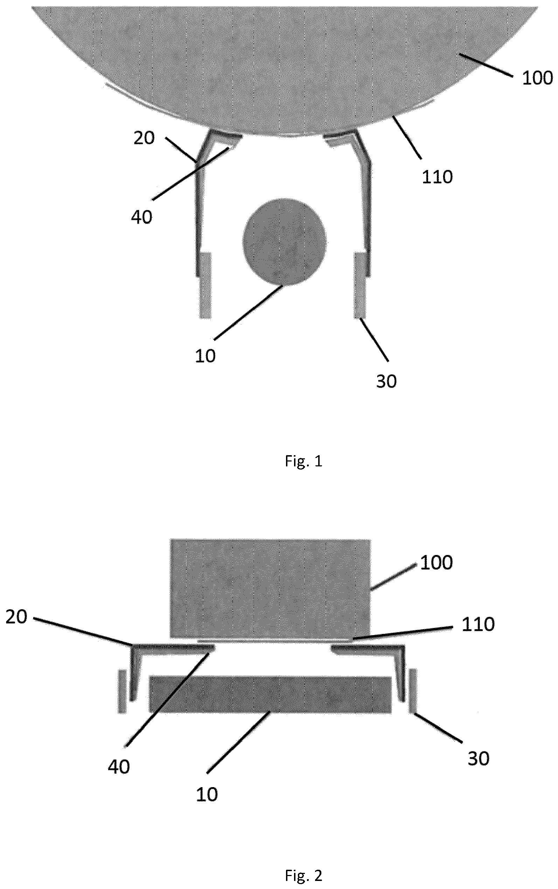

Fig. 1 is a sectional drawing along the coating direction. Fig. 1 shows the cooled coating roller 100 that moves the substrate 110 along the coating window 20. Fig. 1 further shows the deposition source 10 and a cooling device 30.

Fig. 2 is a respective sectional drawing transverse to the coating direction in correspondence with the embodiment shown in Fig. 1. The same reference numerals indicate the same elements and will not be repeated.

As can be seen from Figs. 1 and 2, the coating window 20 accommodates the entire backcoating 40. Although not shown in the figures, the deposition source 10, the coating window 20 and the cooling device 30 are installed on a movable main body. The movable main body is movable with respect to the vacuum chamber (not shown), which comprises the cooled coating roller 100 (also referred to as a substrate carrier). The movable main body opens and closes the deposition chamber (also referred to as the vacuum chamber).

The backcoating 40 is the coating that does not reach the substrate, but rather the coating that is deposited on the coating window20. Thus, the shape of the coating window 20 is preferably configured to receive all or at least a significant amount of the backcoating 40.

In an embodiment, the cooled coating roller may be colled by a vacuum chamber cooling device (not shown), which may be different from the cooling device 30 and may be located in the vacuum chamber.

The coating window 20 comprises an opening towards the substrate 110 to deposit material therethrough. The coating window 20 comprises sidewalls that are directed substantially in a deposition direction and frontwalls substantially perpendicular to the deposition direction (parallel to the substrate), wherein the frontwalls comprise said opening. A first end of the coating window 20 is connected to a cooling device 30. The frontwalls are positioned on a second end of the coating window 20 opposite the first end.

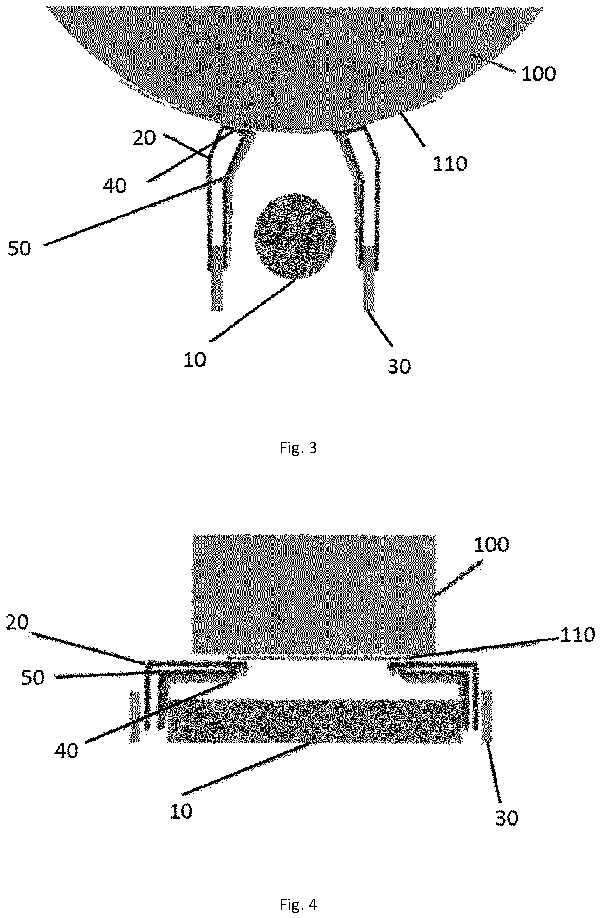

Fig. 3 is a sectional drawing along the coating direction. Fig. 3 shows the cooled coating roller 100 that moves the substrate 110 along the coating window 20. Fig. 3 further shows the deposition source 10, a cooling device 30 and a shield 50.

Fig. 4 is a respective sectional drawing transverse to the coating direction in correspondence with the embodiment shown in Fig. 3. The same reference numerals indicate the same elements and will not be repeated. In general, the embodiment of Figs. 3 and 4 is largely identical to the embodiment of Figs. 1 and 2 (besides the use of an additional shield) and thus the respeticve description thereof is not repeated.

As can be seen from Figs. 3 and 4, the shield 50 accommodates the majority of the backcoating 40, whereas the coating window 20 only accommodates minor parts of the backcoating 40. Thus, the shield 50 may become hot and can deform without negatively affecting the process, whereas the coating window 20 is heated up less (compared to, e.g., the embodiment of Fig. 1).

The shield 50 is located on the inside of the coating window 20 and preferably has a predetermined distance to the coating window 20. As described above, the shield 50 is configured such that a majority of the backcoating 40 is deposited on the shield 50 and only a small amount of backcoating 40 is deposited on the coating window 20, in particular around the opening of the coating window 20.

In an embodiment, the shield 50 comprises sidewalls that substantially follow the sidewalls of the coating window 20. In another embodiment, the shield 50 is located close to the opening of the coating window 20, preferably with a predetermined distance from the opening of the coating window 20. The predetermined distance is preferably chosen as small as possible and such that the shield 50 does not negatively influence the coating process. The predetermined distance may vary over the extend of the shield 50.

In other words, the shield 50 comprises an opening in its frontwalls, which may be slightly larger than the opening provided in the coating window 20. There may be a gap between the opening of the shield 50 and the opening of the coating window 20. It is this gap that receives some (small) amount of backcoating 40, which thus may reach the coating window 20 as described above.

In an embodiment, the coating window 20 may be provided with soldered-on heat sinks in the substrate area. This may allow a larger amount of coating.

In view of the above, the use of a cooling device 30 that directly cools the coating window 20 (that is located on a movable main body) and/or the use of a shield 50 allows a one-piece coating window 20, which can be changed with little effort. In addition, it is expected that compared to conventional methods, the coating window 20 remains colder in the process. This allows to run at higher outputs or higher coating rates. Thus, the product quality is improved and productivity is increased.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

## Claims

1. Device for vacuum deposition systems, comprising:
a movable main body,
at least one deposition source (10) mounted on the movable main body,
at least one coating window (20) associated with the at least one deposition source (10) and mounted on the movable main body, and
at least one cooling device (30) connected to the at least one coating window (20) and mounted on the movable main body.

2. The device of claim 1, wherein the movable main body is movable relative to a vacuum chamber of a vacuum deposition system such that the movable main body can be inserted into and withdrawn from the vacuum chamber.

3. The device of claim 1 or 2, wherein the at least one coating window (20) comprises a housing with an opening.

4. The device of claim 3, wherein the at least one depositon source (10) is configured to deposit material within a deposition space with a main deposition direction aligned towards the opening of the at least one coating window (20).

5. The device of claim 4, wherein the housing of the at least one coating window (20) is configured to surround the at least one deposition source (10) within the deposition space such that material that is not deposited through the opening is deposited on an inner side of the housing.

6. The device of any one of claims 1 to 5, wherein each of the at least one coating window (20) is associated with a respective one of the at least one deposition source (10).

7. The device of any one of claims 1 to 6, further comprising at least one shield (50) located between the at least one deposition source (10) and the at least one coating window (20), wherein the at least one shield (50) and the at least one coating window (20) are connected to the at least one cooling device (30), wherein the at least one shield (50) and the at least one coating window (20) are preferably connected to separate cooling devices (30) or more preferably to one and the same cooling device (30).

8. The device of claim 7, wherein the at least one shield (50) is configured to shield a majority of the at least one coating window (20).

9. The device of claim 7 or 8, wherein the at least one shield (50) comprises a shield housing with a shield opening, wherein the shield opening is aligned with the opening of the at least one coating window (20).

10. The device of claim 9, wherein the shield housing is located between the at least one deposition source (10) and the at least one coating window (20) with a predetermined spacing.

11. The device of any one of claims 7 to 10, wherein the shield opening is larger by a predetermined amount than the opening of the at least one coating window (20).

12. System for vacuum deposition, comprising:
a vacuum chamber,
a substrate carrier (100) located within the vacuum chamber and having a vacuum chamber cooling device configured to cool the subtsrate carrier (100), and
a device according to any one of claims 1 to 11.

13. The system of claim 12, wherein the movable main body is movable relative to the vacuum chamber such that the movable main body can be inserted into and withdrawn from the vacuum chamber.

14. The system of claim 12 or 13, wherein the substrate carrier (100) is configured to hold a substrate (110), and wherein the substrate carrier (100) is aligned with the at least one coating window (20) such that materials can be deposited onto the subtsrate (110) through the at least one coating window (20).

15. The device of any one of claims 12 to 14, wherein the vacuum chamber cooling device and the at least one cooling device (30) are separate devices.
